(19) Europäisches Patentamt
European Patent Office
Office européen des brevets

(11) **EP 3 164 936 B1**

(12) **EUROPÄISCHE PATENTSCHRIFT**

(45) Veröffentlichungstag und Bekanntmachung des Hinweises auf die Patenterteilung:
**15.08.2018 Patentblatt 2018/33**

(21) Anmeldenummer: **15727972.0**

(22) Anmeldetag: **09.06.2015**

(51) Int Cl.:
*H02P 25/22* (2006.01)   *H02P 23/14* (2006.01)

(86) Internationale Anmeldenummer:
**PCT/EP2015/062787**

(87) Internationale Veröffentlichungsnummer:
**WO 2016/000916 (07.01.2016 Gazette 2016/01)**

(54) **VERFAHREN ZUR BESTIMMUNG DER PHASENSTRÖME EINER ELEKTRISCHEN MASCHINE MIT EINEM STROMRICHTER**

METHOD FOR DETERMINING THE PHASE CURRENTS OF AN ELECTRIC MACHINE HAVING A CURRENT CONVERTER

PROCÉDÉ DE DÉTERMINATION DES COURANTS DE PHASES D'UNE MACHINE ÉLECTRIQUE COMPRENANT UN CONVERTISSEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **04.07.2014 DE 102014213077**

(43) Veröffentlichungstag der Anmeldung:
**10.05.2017 Patentblatt 2017/19**

(73) Patentinhaber:
• **Robert Bosch GmbH**
**70442 Stuttgart (DE)**
Benannte Vertragsstaaten:
**AL AT BE BG CH CY CZ DE DK EE FI FR GB GR HR HU IE IS IT LI LT LU LV MC MK MT NL NO PL PT RO RS SE SI SK SM TR**
• **SEG Automotive Germany GmbH**
**70499 Stuttgart (DE)**

(72) Erfinder:
• **MOTAGANAHALLI SRINIVASAMURTHY, Arunkumar**
**Bangalore 560072 (IN)**
• **ROESNER, Julian**
**74199 Untergruppenbach (DE)**

(56) Entgegenhaltungen:
EP-A1- 2 360 483       WO-A2-2014/044526
DE-A1-102011 003 897

EP 3 164 936 B1

**Beschreibung**

Die vorliegende Erfindung betrifft ein Verfahren zur Bestimmung der Phasenströme einer elektrischen Maschine mit einem Stromrichter sowie eine Recheneinheit und ein Computerprogramm zu dessen Durchführung.

Stand der Technik

Generatoren zur Umwandlung mechanischer Energie in elektrische Energie sind bekannt. In Kraftfahrzeugen werden in der Regel Klauenpolgeneratoren verwendet. Diese können mit elektrischer Erregung ausgestattet sein. Da Klauenpolgeneratoren Drehstrom erzeugen, ist für die in Kraftfahrzeugen üblichen Gleichspannungsbordnetze eine Gleichrichtung erforderlich. Hierzu können Gleichrichter mit Halbleiterdioden und/oder aktiven Schaltelementen verwendet werden.

Generatoren, die auch zum Fahrzeugantrieb eingesetzt werden können (also auch motorisch betreibbar sind), sind aus dem Bereich der Hybridfahrzeuge bekannt. Ziel ist hierbei, den Verbrennungsmotor bei niedrigen Drehzahlen, bei denen dieser noch nicht sein volles Drehmoment liefert, zu unterstützen (Boostbetrieb, Turbolochkompensation). Außerdem kann durch ein aktives elektrisches Bremsen (generatorischer Betrieb) die kinetische Energie des Fahrzeuges in das elektrische Bordnetz zurückgespeist werden (Rekuperation). Für den generatorischen Betrieb kann der Stromrichter als aktiver Gleichrichter betrieben werden, bei dem die Highside- und Lowside-Schalter phasenspannungsabhängig umgeschaltet werden. Beispielsweise werden die Lowside-Schalter geschlossen, wenn die Phasenspannung negativ ist, und die Highside-Schalter, wenn die Phasenspannung größer als die Batteriespannung ist. Um das aktive Bremsmoment genau zu steuern, ist die Kenntnis der Phasenströme wichtig.

Die Messung der Phasenströme kann über Messwiderstände, sogenannte Shunts, erfolgen. In der Regel sind diese Shunts nicht direkt in den Phasen des Antriebs verbaut, sondern in einem Lowside-Zweig des Stromrichters. Eine phasenindividuelle Strommessung mit Lowside-Shunts ist aus dem Bereich der Ansteuerung von Elektromotoren bekannt. Allerdings muss hier, wie in der DE 103 27 690 B4 oder der DE 10 2012 217 116 A1 angegeben, die Strommessung mit der Ansteuerung synchronisiert werden. Dies ist relativ aufwendig. Weiterhin problematisch bei der aktiven Gleichrichtung ist, dass zu keinem Zeitpunkt alle Lowside-Schalter geschlossen sind. Jedoch können auch bei Strommessungen im Lowside-Zweig bei geöffnetem Schalter Ströme ungleich Null, z.B. wegen Messrauschen, Sensoroffsets usw., gemessen werden. Dies erschwert die Auswertung weiter.

Es ist daher wünschenswert, ein Verfahren anzugeben, mit dem auch in einem aktiven Gleichrichtbetrieb alle Phasenströme möglichst einfach bestimmt werden können.

Offenbarung der Erfindung

Erfindungsgemäß werden ein Verfahren zur Bestimmung der Phasenströme einer elektrischen Maschine mit einem Stromrichter sowie eine Recheneinheit und ein Computerprogramm zu dessen Durchführung mit den Merkmalen der unabhängigen Patentansprüche vorgeschlagen. Vorteilhafte Ausgestaltungen sind jeweils Gegenstand der Unteransprüche sowie der nachfolgenden Beschreibung.

Vorteile der Erfindung

Im Rahmen der Erfindung wird eine Möglichkeit vorgeschlagen, alle Phasenströme einer elektrischen Maschine mit einer Anzahl von Phasen durch im Wesentlichen gleichzeitige Messung aller Lowside-Zweig-Ströme und Verrechnung der Messwerte zu bestimmen. Von allen gemessenen Lowside-Zweig-Strömen werden dann mindestens zwei und weniger als die Anzahl der Phasen für die Berechnung der Phasenströme herangezogen. Dabei werden die heranzuziehenden Phasen anhand des Messwerts ausgewählt, nämlich die beiden gemessenen Lowside-Zweig-Strömen werden mit der betragsmäßig größten Amplitude für die Berechnung der Phasenströme herangezogen. Dadurch ist der aktuelle Schaltzustand in den einzelnen Zweigen unerheblich. "Falsche" Lowside-Zweig-Ströme, die durch Rauschen, Sensoroffsets usw. gemessen werden, obwohl der zugehörige Lowside-Schalter geschlossen ist, sind betragsmäßig immer kleiner als "richtige" Lowside-Zweig-Ströme, die durch den geöffneten Lowside-Schalter fließen. Auch eine Synchronisierung der Messung mit der Schaltfolge ist aus demselben Grund nicht mehr nötig. Vielmehr kann die Messung aller Lowside-Zweig-Ströme zu beliebigen Zeitpunkten und unabhängig von Schaltzeiten des aktiven Gleichrichtbetriebs stattfinden. Zweckmäßigerweise werden alle Lowside-Zweig-Ströme im Wesentlichen gleichzeitig gemessen. Dies kann insbesondere durch eine entsprechende Anzahl von parallelen AD-Wandlungen oder z.B. durch einen Multiplexer und serielle AD-Wandlungen, solange diese seriellen AD-Wandlungen so schnell durchgeführt werden, dass keine signifikante Veränderung des Phasenstroms während dessen zu erwarten ist, erfolgen. Zweckmäßigerweise werden die Lowside-Zweig-Ströme in einem regelmäßigen zeitlichen Raster gemessen.
Die Erfindung eignet sich für alle mehrphasigen Maschinen mit mindestens vier Phasen. Die Phasenströme sind aus einer geeigneten Anzahl von mindestens zwei und höchsten N-1, wobei N die Anzahl der Phasen ist, Lowside-Zweig-Strömen immer berechenbar, da die Winkelabstände zwischen den Phasen für jede Maschine bekannt sind. Eine besonders geeignete Auswahl ist die der zwei betragsmäßig größten Lowside-Zweig-Ströme. Dies wird weiter unten am Beispiel einer fünfphasigen Maschine näher ausgeführt. Besondere Vorteile entfaltet die Erfindung bei Maschinen mit mehr als vier Phasen, da dort die Anzahl der berechneten Phasenströme immer gleich oder größer der Anzahl der beiden betragsmäßig größten Lowside-Zweig-Ströme ist, d.h. aus nur zwei validen Messwerten können alle invaliden Werte berechnet werden.

Die Erfindung eignet sich besonders vorteilhaft zur Verwendung in Hybrid- bzw. Rekuperationsantriebstechniken, da dort die Kenntnis aller Phasenströme die genaue Einstellung eines aktiven Bremsmoments ermöglicht.

Eine erfindungsgemäße Recheneinheit, z.B. ein Steuergerät eines eines Kraftfahrzeugs, ist, insbesondere programmtechnisch, dazu eingerichtet, ein erfindungsgemäßes Verfahren durchzuführen.

Auch die Implementierung des Verfahrens in Form von Software ist vorteilhaft, da dies besonders geringe Kosten verursacht, insbesondere wenn ein ausführendes Steuergerät noch für weitere Aufgaben genutzt wird und daher ohnehin vorhanden ist. Geeignete Datenträger zur Bereitstellung des Computerprogramms sind insbesondere Disketten, Festplatten, Flash-Speicher, EEPROMs, CD-ROMs, DVDs u.a.m. Auch ein Download eines Programms über Computernetze (Internet, Intranet usw.) ist möglich.

Weitere Vorteile und Ausgestaltungen der Erfindung ergeben sich aus der Beschreibung und der beiliegenden Zeichnung.

Es versteht sich, dass die vorstehend genannten und die nachfolgend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist anhand eines Ausführungsbeispiels/von Ausführungsbeispielen in der Zeichnung schematisch dargestellt und wird im Folgenden unter Bezugnahme auf die Zeichnung ausführlich beschrieben.

Kurze Beschreibung der Zeichnungen

Figur 1 zeigt eine elektrische Maschine mit einem Stromrichter, wie sie der Erfindung zugrunde liegen kann, in schematischer Darstellung.
Figur 2 zeigt ein Ansteuerschema für aktive Gleichrichtung einer elektrischen Maschine mit einem Stromrichter gemäß Figur 1 in schematischer Darstellung.

Ausführungsform(en) der Erfindung

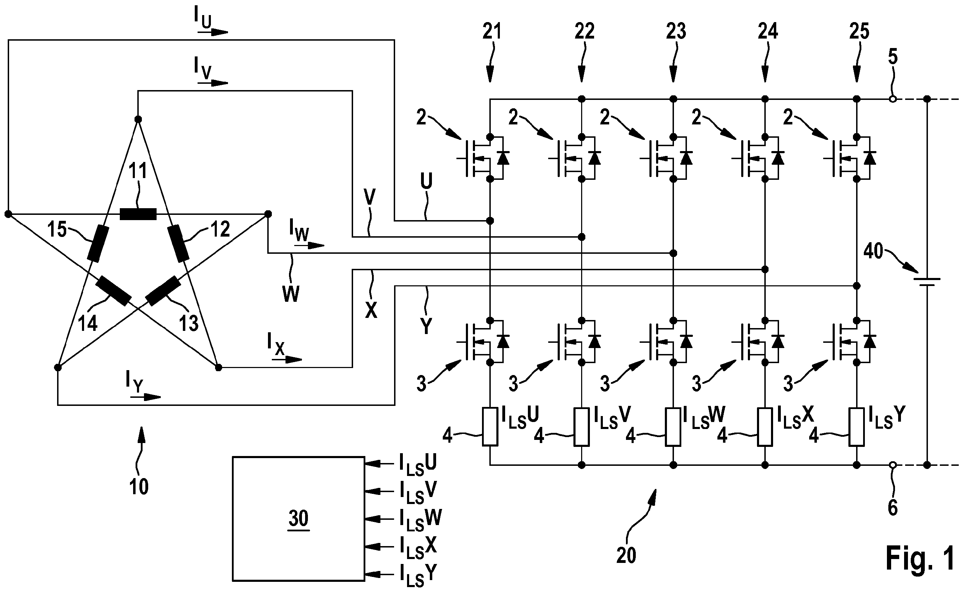

Figur 1 zeigt die zur Veranschaulichung der Erfindung wesentlichen Elemente einer elektrischen Maschine mit einem Stromrichter in stark vereinfachter Darstellung, wie sie Teil eines Kraftfahrzeugbordnetzes sein kann. Hiervon umfasst ist ein fünfphasiger Ständer (bzw. Stator) 10. Der fünfphasige Ständer 10 weist insgesamt fünf Ständerwicklungsstränge (auch als Statorwicklungen bezeichnet) 11 bis 15 auf. Ein Läufer (bzw. Rotor) ist der Übersichtlichkeit halber nicht dargestellt.

Der fünfphasige Ständer 10 ist mit seinen fünf Ständerwicklungssträngen 11 bis 15 an einen Stromrichter 2 angebunden, der fünf Stromrichterbrücken 21 bis 25 mit aktiven Schaltelementen 2, 3, beispielsweise MOSFETs, als Schalter aufweist. Die fünf Ständerwicklungsstränge 11 bis 15 bzw. die fünf Stromrichterbrücken 21 bis 25 definieren die fünf Phasen U bis Y der elektrischen Maschine. Der Stromrichter 2 kann als Gleichrichter (üblicherweise bei einem generatorischen Betrieb der elektrischen Maschine zum Versorgen des Bordnetzes) oder als Wechselrichter (üblicherweise bei einem motorischen Betrieb der elektrischen Maschine) betrieben werden.

Die aktiven Schaltelemente 2, 3 sind über Stromschienen mit den Ständerwicklungssträngen 11 bis 15 einerseits und Gleichspannungsanschlüssen 5, 6 andererseits verbunden. Die Gleichspannungsanschlüsse 5, 6 können mit einem elektrischen Energiespeicher in einem Bordnetz, beispielsweise einer Batterie 40, verbunden sein. Der obere Gleichspannungsanschluss 5 ist dabei mit dem positiven Batteriepol, der untere Gleichspannungsanschluss 6 mit dem negativen Batteriepol bzw. Masse verbunden. Die aktiven Schaltelemente 2 sind damit im sogenannten oberen Gleichrichterzweig angeordnet, die aktiven Schaltelemente 3 im unteren Gleichrichterzweig. Bei den aktiven Schaltelementen 2 handelt es sich damit um sogenannte Highside-Schaltelemente als obere Schalter, bei den aktiven Schaltelementen 3 um sogenannte Lowside-Schaltelemente als untere Schalter. Man spricht auch von einem Highside-Zweig (vom Mittelpunkt der jeweiligen Stromrichterbrücken 21 bis 25 über die Schaltelemente 2 zu dem Gleichspannungsanschluss 5) bzw. einem Lowside-Zweig (vom Mittelpunkt der jeweiligen Stromrichterbrücken 21 bis 25 über die Schaltelemente 3 zu dem Gleichspannungsanschluss 6).

Eine Strommessung erfolgt über Messwiderstände (Shunts) 4 in den Lowside-Zweigen des Stromrichters 20. Bekanntermaßen wird hierzu die an dem Messwiderstand abfallende Spannung gemessen, hier insbesondere an einem Analog/Digital-Wandlereingang eines Steuergeräts 30.

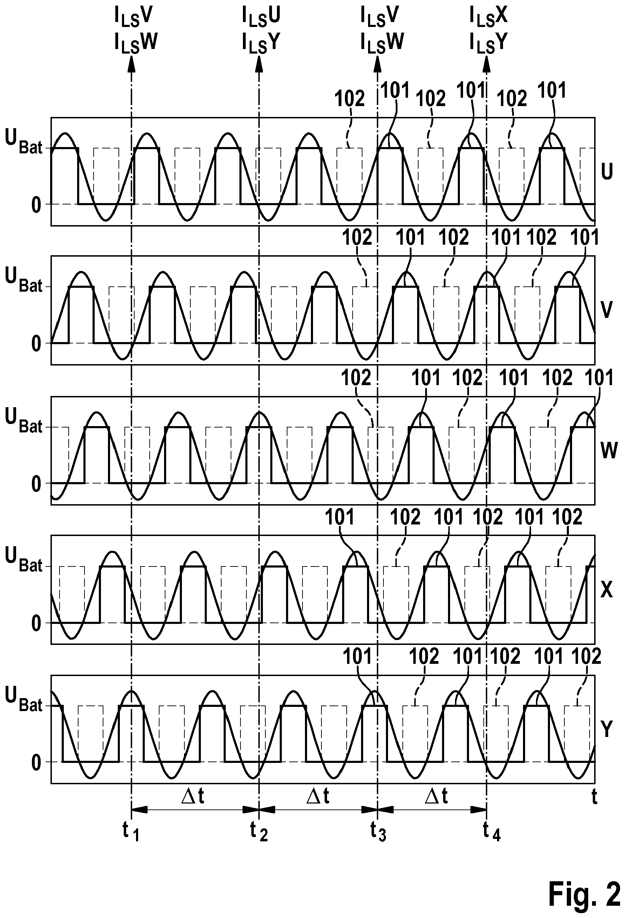

Ein Verfahren zur Bestimmung aller Phasenströme gemäß einer vorteilhaften Ausführungsform der Erfindung wird unter Bezugnahme auf Figur 2 beschrieben. Das Steuergerät 30 ist programmtechnisch zur Durchführung des Verfahrens eingerichtet.

In Figur 2 sind übereinander die zeitlichen Verläufe der Phasenspannungen der fünf Phasen U, V, W, X und Y dargestellt. Eine Batteriespannung einer zwischen dem oberen Gleichspannungsanschluss 5 und dem unteren Gleichspannungsanschluss 6 angeschlossenen Batterie ist mit $U_{Bat}$, Masse mit "0" gekennzeichnet. Bei einem typischen Hybridantrieb ist der Stromrichter 20 mit einem Hochspannungsbordnetz mit z.B. 48 V verbunden.

Gemäß dem aktiven Gleichrichtbetrieb wird jedes der Highside-Schaltelemente 2 geschlossen, solange die zugehörige Phasenspannung gegenüber Masse größer als die am oberen Gleichspannungsanschluss 5 anliegende Batteriespannung gegenüber Masse ist. Das Schaltschema ist jeweils mit 101 bezeichnet.

Weiterhin wird gemäß dem aktiven Gleichrichtbetrieb jedes der Lowside-Schaltelemente 3 geschlossen, solange die zugehörige Phasenspannung gegenüber Masse kleiner als die am unteren Gleichspannungsanschluss 5 anliegende Masse ist. Das Schaltschema ist jeweils mit 102 bezeichnet.

Im Rahmen der Erfindung ist es nun möglich, alle Phasenströme $I_U$, $I_V$, $I_W$, $I_X$, $I_Y$ durch zweckmäßigerweise gleichzeitige Messung aller Lowside-Zweig-Ströme $I_{LS}U$, $I_{LS}V$, $I_{LS}W$, $I_{LS}X$, $I_{LS}Y$ zu bestimmen. Von allen gemessenen Lowside-Zweig-Strömen werden dann die beiden mit der betragsmäßig größten Amplitude für die Berechnung der Phasenströme herangezogen. Diese sind in Figur 2 mit "valid" gekennzeichnet, die anderen drei mit "invalid". Beispielhafte Messzeitpunkte sind durch vertikale gestrichelte Linien gekennzeichnet. Die Messzeitpunkte können insbesondere beliebig und unabhängig von Schaltzeiten des aktiven Gleichrichtbetriebs liegen. Im vorliegenden Beispiel sind die Messzeitpunkte äquidistant in einem regelmäßigen zeitlichen Raster $\Delta t$.

Aus der Kenntnis der Winkelabstände zwischen den Phasen (hier 72°) kann jeder Phasenstrom als Funktion der zwei betragsmäßig größten, d.h. validen Lowside-Zweig-Ströme berechnet werden. Dafür werden folgende Umrechnungsfaktoren definiert:

$$\text{Faktor11} = \sin(216°) / \sin(288°)$$

$$\text{Faktor21} = \cos(216°) - (\sin(216°)/\tan(288°)$$

$$\text{Faktor12} = \sin(144°) / \sin(216°)$$

$$\text{Faktor22} = \cos(144°) - (\sin(144°)/\tan(216°)$$

$$\text{Faktor13} = \sin(72°) / \sin(144°)$$

$$\text{Faktor23} = \cos(72°) - (\sin(72°)/\tan(144°)$$

Im vorliegenden Beispiel sind demnach zu einem Messzeitpunkt $t_1$ die Lowside-Zweig-Ströme $I_{LS}V$ und $I_{LS}W$ valide, welche damit gleichzeitig die Phasenströme $I_V$ bzw. $I_W$ sind. Die anderen Phasenströme ergeben sich daraus zu:

$$I_X = (I_{LS}V - I_{LS}W \cdot {}^* \text{Faktor11}) / \text{Faktor21}$$

$$I_Y = (I_{LS}V - I_{LS}W * \text{Faktor12}) / \text{Faktor22}$$

$$I_U = (I_{LS}V - I_{LS}W * \text{Faktor13}) / \text{Faktor23}$$

Zu einem Messzeitpunkt $t_2$ sind die Lowside-Zweig-Ströme $IL_SU$ und $I_{LS}Y$ valide, welche damit gleichzeitig die Phasenströme $I_U$ bzw. $I_Y$ sind. Die anderen Phasenströme ergeben sich daraus zu:

$$I_V = (I_{LS}Y - I_{LS}U * \text{Faktor11}) / \text{Faktor21}$$

$$I_W = (I_{LS}Y - I_{LS}U * \text{Faktor12}) / \text{Faktor22}$$

$$I_X = (I_{LS}Y - I_{LS}U * \text{Faktor13}) / \text{Faktor23}$$

Zu einem Messzeitpunkt $t_4$ sind die Lowside-Zweig-Ströme $I_{LS}X$ und $I_{LS}Y$ valide, welche damit gleichzeitig die Phasenströme $I_X$ bzw. $I_Y$ sind. Die anderen Phasenströme ergeben sich daraus zu:

$$I_U = (I_{LS}X - I_{LS}Y * \text{Faktor11}) / \text{Faktor21}$$

$$I_V = (I_{LS}X - I_{LS}Y * \text{Faktor12}) / \text{Faktor22}$$

$$I_W = (I_{LS}X - I_{LS}Y * \text{Faktor13}) / \text{Faktor23}$$

Für valide Lowside-Zweig-Ströme $I_{LS}U$ und $I_{LS}V$ ergeben sich die anderen Phasenströme zu:

$$I_W = (I_{LS}U - I_{LS}V * \text{Faktor11}) / \text{Faktor21}$$

$$I_X = (I_{LS}U - I_{LS}V * \text{Faktor12}) / \text{Faktor22}$$

$$I_Y = (I_{LS}U - I_{LS}V * \text{Faktor13}) / \text{Faktor23}$$

Schließlich ergeben sich für valide Lowside-Zweig-Ströme $I_{LS}W$ und $I_{LS}X$ die anderen Phasenströme zu:

$$I_Y = (I_{LS}W - I_{LS}X * \text{Faktor11}) / \text{Faktor21}$$

$$I_U = (I_{LS}W - I_{LS}X * \text{Faktor12}) / \text{Faktor22}$$

$$I_V = (I_{LS}W - I_{LS}X * \text{Faktor13}) / \text{Faktor23}$$

Insgesamt können somit mittels der Erfindung alle Phasenströme einer elektrischen Maschine mit mindestens vier Phasen auch dann bestimmt werden, wenn der Stromrichter als aktiver Gleichrichter betrieben wird.

## Patentansprüche

1. Verfahren zur Bestimmung der Phasenströme ($I_U$, $I_V$, $I_W$, $I_X$, $I_Y$), einer elektrischen Maschine mit einem Stromrichter (20) und einem Ständer (10) mit mindestens vier Phasen (U, V, W, X, Y), wobei der Stromrichter (20) für jede der mindestens vier Phasen (U, V, W, X, Y) einen oberen Zweig mit einem oberen Schalter (2) und einen unteren Zweig mit einem unteren Schalter (3) aufweist, wobei alle oberen Zweige mit einem oberen Gleichspannungsanschluss (5) und alle unteren Zweige mit einem unteren Gleichspannungsanschluss (6) verbunden sind, wobei der Stromrichter (20) in einem aktiven Gleichrichtbetrieb betrieben wird, in dem jeder obere Schalter (2) nur geschlossen ist, solange eine Phasenspannung an dem betreffenden oberen Schalter (2) gegenüber Masse größer als eine Spannung an dem oberen Gleichspannungsanschluss (5) gegenüber Masse ist, und wobei jeder untere Schalter nur geschlossen ist, solange eine Phasenspannung an dem betreffenden unteren Schalter (3) gegenüber Masse kleiner als eine Spannung an dem unteren Gleichspannungsanschluss (6) gegenüber Masse ist, wobei Phasenzweigströme ($I_{LS}U$, $I_{LS}V$, $I_{LS}W$, $I_{LS}X$, $I_{LS}Y$) in allen unteren Zweigen gemessen werden, wobei die Phasenströme ($I_U$, $I_V$, $I_W$, $I_X$, $I_Y$) aus einer Anzahl, die größer als Eins und kleiner als die Anzahl der mindestens vier Phasen (U, V, W, X, Y) ist, von Phasenzweigströmen ($I_{LS}U$, $I_{LS}V$, $I_{LS}W$, $I_{LS}X$, $I_{LS}Y$) bestimmt werden, **dadurch gekennzeichnet, dass** die Phasenströme ($I_U$, $I_V$, $I_W$, $I_X$, $I_Y$) aus den zwei betragsmäßig größten Phasenzweigströmen ($I_{LS}U$, $I_{LS}V$, $I_{LS}W$, $I_{LS}X$, $I_{LS}Y$) bestimmt werden.

2. Verfahren nach Anspruch 1, wobei die Phasenzweigströme ($I_{LS}U$, $I_{LS}V$, $I_{LS}W$, $I_{LS}X$, $I_{LS}Y$) in allen unteren Zweigen gleichzeitig gemessen werden.

3. Verfahren nach einem der vorstehenden Ansprüche, wobei die Phasenzweigströme ($I_{LS}U$, $I_{LS}V$, $I_{LS}W$, $I_{LS}X$, $I_{LS}Y$) mittels jeweils einen Messwiderstands (4) in allen unteren Zweigen gemessen werden.

4. Verfahren nach einem der vorstehenden Ansprüche, wobei die Phasenzweigströme ($I_{LS}U$, $I_{LS}V$, $I_{LS}W$, $I_{LS}X$, $I_{LS}Y$) in allen unteren Zweigen in einem regelmäßigen zeitlichen Raster gemessen werden.

5. Verfahren nach einem der vorstehenden Ansprüche, wobei die Phasenzweigströme ($I_{LS}U$, $I_{LS}V$, $I_{LS}W$, $I_{LS}X$, $I_{LS}Y$) in allen unteren Zweigen unabhängig von Schaltzeitpunkten des aktiven Gleichrichtbetriebs gemessen werden.

6. Verfahren nach einem der vorstehenden Ansprüche, wobei die Phasenströme ($I_U$, $I_V$, $I_W$, $I_X$, $I_Y$) aus der Anzahl von Phasenzweigströmen ($I_{LS}U$, $I_{LS}V$, $I_{LS}W$, $I_{LS}X$, $I_{LS}Y$) unter Berücksichtigung von Winkelabständen zwischen den mindestens vier Phasen (U, V, W, X, Y) bestimmt werden.

7. Verfahren nach einem der vorstehenden Ansprüche, wobei zwischen dem oberen Gleichspannungsanschluss (5) und dem unteren Gleichspannungsanschluss (6) eine Batteriespannung angelegt wird.

8. Recheneinheit, die dazu eingerichtet ist, ein Verfahren nach einem der vorstehenden Ansprüche durchzuführen.

9. Kraftfahrzeugbordnetz mit einer elektrischen Maschine mit einem Stromrichter (20) und einem Ständer (10) mit mindestens vier Phasen (U, V, W, X, Y), wobei der Stromrichter (20) für jede der mindestens vier Phasen (U, V, W, X, Y) einen oberen Zweig mit einem oberen Schalter (2) und einen unteren Zweig mit einem unteren Schalter (3) aufweist, wobei alle oberen Zweige mit einem oberen Gleichspannungsanschluss (5) und alle unteren Zweige mit einem unteren Gleichspannungsanschluss (6) verbunden sind, und mit einer Recheneinheit gemäß Anspruch 8.

10. Kraftfahrzeugbordnetz nach Anspruch 9, mit einem elektrischen Energiespeicher (40), der zwischen dem oberen Gleichspannungsanschluss (5) und dem unteren Gleichspannungsanschluss (6) angeschlossen ist.

11. Computerprogramm, das eine Recheneinheit dazu veranlasst, ein Verfahren nach einem der Ansprüche 1 bis 8 durchzuführen, wenn es auf der Recheneinheit ausgeführt wird.

12. Maschinenlesbares Speichermedium mit einem darauf gespeicherten Computerprogramm nach Anspruch 12.

**Claims**

1. Method for determining the phase currents ($I_U$, $I_V$, $I_W$, $I_X$, $I_Y$) of an electric machine having a converter (20) and a stator (10) having at least four phases (U, V, W, X, Y), wherein, for each of the at least four phases (U, V, W, X, Y), the converter (20) has an upper branch having an upper switch (2) and a lower branch having a lower switch (3), wherein all the upper branches are connected to an upper DC voltage connection (5) and all the lower branches are connected to a lower DC voltage connection (6), wherein the converter (20) is operated in an active rectifying operation in which each upper switch (2) is only closed as long as a phase voltage at the relevant upper switch (2) with respect to earth is greater than a voltage at the upper DC voltage connection (5) with respect to earth, and wherein each lower switch is only closed as long as a phase voltage at the relevant lower switch (3) with respect to earth is lower than a voltage at the lower DC voltage connection (6) with respect to earth, wherein phase branch currents ($I_{LS}U$, $I_{LS}V$, $I_{LS}W$, $I_{LS}X$, $I_{LS}Y$) in all the lower branches are measured,

wherein the phase currents ($I_U$, $I_V$, $I_W$, $I_X$, $I_Y$) are determined from a number of phase branch currents ($I_{LS}U$, $I_{LS}V$, $I_{LS}W$, $I_{LS}X$, $I_{LS}Y$) that is greater than one and less than the number of the at least four phases (U, V, W, X, Y), **characterized in that** the phase currents ($I_U$, $I_V$, $I_W$, $I_X$, $I_Y$) are determined from the two phase branch currents ($I_{LS}U$, $I_{LS}V$, $I_{LS}W$, $I_{LS}X$, $I_{LS}Y$) that are greatest in terms of magnitude.

2. Method according to Claim 1, wherein the phase branch currents ($I_{LS}U$, $I_{LS}V$, $I_{LS}W$, $I_{LS}X$, $I_{LS}Y$) in all the lower branches are measured at the same time.

3. Method according to either of the preceding claims, wherein the phase branch currents ($I_{LS}U$, $I_{LS}V$, $I_{LS}W$, $I_{LS}X$, $I_{LS}Y$) are measured by means of in each case one measuring resistor (4) in all the lower branches.

4. Method according to one of the preceding claims, wherein the phase branch currents ($I_{LS}U$, $I_{LS}V$, $I_{LS}W$, $I_{LS}X$, $I_{LS}Y$) in all the lower branches are measured in a regular time frame.

5. Method according to one of the preceding claims, wherein the phase branch currents ($I_{LS}U$, $I_{LS}V$, $I_{LS}W$, $I_{LS}X$, $I_{LS}Y$) in all the lower branches are measured independently of switching times of the active rectifying operation.

6. Method according to one of the preceding claims, wherein the phase currents ($I_U$, $I_V$, $I_W$, $I_X$, $I_Y$) are determined from the number of phase branch currents ($I_{LS}U$, $I_{LS}V$, $I_{LS}W$, $I_{LS}X$, $I_{LS}Y$) taking into account angular spacings between the at least four phases (U, V, W, X, Y) .

7. Method according to one of the preceding claims, wherein a battery voltage is applied between the upper DC voltage connection (5) and the lower DC voltage connection (6).

8. Computing unit, which is configured to carry out a method according to one of the preceding claims.

9. On-board motor vehicle electrical system having an electric machine having a converter (20) and a stator (10) having at least four phases (U, V, W, X, Y), wherein, for each of the at least four phases (U, V, W, X, Y), the converter (20) has an upper branch having an upper switch (2) and a lower branch having a lower switch (3), wherein all the upper branches are connected to an upper DC voltage connection (5) and all the lower branches are connected to a lower DC voltage connection (6), and having a computing unit according to Claim 8.

10. On-board motor vehicle electrical system according to Claim 9, having an electrical energy store (40), which is connected between the upper DC voltage connection (5) and the lower DC voltage connection (6).

11. Computer program, which prompts a computing unit to carry out a method according to one of Claims 1 to 8 when said program is executed on the computing unit.

12. Machine-readable storage medium having a computer program according to Claim 12 stored thereon.

**Revendications**

1. Procédé de détermination des courants de phase ($I_U$, $I_V$, $I_W$, $I_X$, $I_Y$) d'une machine électrique comprenant un convertisseur de courant (20) et un stator (10) ayant au moins quatre phases (U, V, W, X, Y), le convertisseur de courant (20) possédant pout chacune des au moins quatre phases (U, V, W, X, Y) une branche supérieure comportant un commutateur supérieur (2) et une branche inférieure comportant un commutateur inférieur (3),
toutes les branches supérieures étant reliées à une borne de tension continue supérieure (5) et toutes les branches inférieures à une borne de tension continue inférieure (6),
le convertisseur de courant (20) fonctionnant dans un régime de redressement actif dans lequel chaque commutateur supérieur (2) n'est fermé que tant qu'une tension de phase au niveau du commutateur supérieur (2) concerné par rapport à la masse est supérieure à une tension au niveau de la borne de tension continue supérieure (5) par rapport à la masse,
et chaque commutateur inférieur n'étant fermé que tant qu'une tension de phase au niveau du commutateur inférieur (3) concerné par rapport à la masse est inférieure à une tension au niveau de la borne de tension continue inférieure par rapport à la masse,
les courants de branche de phase ($I_{LS}U$, $I_{LS}V$, $I_{LS}W$, $I_{LS}X$, $I_{LS}Y$) dans toutes les phases inférieures étant mesurés,
les courants de phase ($I_U$, $I_V$, $I_W$, $I_X$, $I_Y$) étant déterminés à partir d'un nombre de courants de branche de phase

($I_{LS}U$, $I_{LS}V$, $I_{LS}W$, $I_{LS}X$, $I_{LS}Y$) qui est inférieur au nombre des au moins quatre phases (U, V, W, X, Y), **caractérisé en ce que** les courants de phase ($I_U$, $I_V$, $I_W$, $I_X$, $I_Y$) sont déterminés à partir des courants de branche de phase ($I_{LS}U$, $I_{LS}V$, $I_{LS}W$, $I_{LS}X$, $I_{LS}Y$) dont les valeurs sont les plus élevées.

2. Procédé selon la revendication 1, les courants de branche de phase ($I_{LS}U$, $I_{LS}V$, $I_{LS}W$, $I_{LS}X$, $I_{LS}Y$) dans toutes les branches inférieures étant mesurés simultanément.

3. Procédé selon l'une des revendications précédentes, les courants de branche de phase ($I_{LS}U$, $I_{LS}V$, $I_{LS}W$, $I_{LS}X$, $I_{LS}Y$) dans toutes les branches inférieures étant mesurés au moyen d'une résistance de mesure (4) respective.

4. Procédé selon l'une des revendications précédentes, les courants de branche de phase ($I_{LS}U$, $I_{LS}V$, $I_{LS}W$, $I_{LS}X$, $I_{LS}Y$) dans toutes les branches inférieures étant mesurés dans une grille temporelle régulière.

5. Procédé selon l'une des revendications précédentes, les courants de branche de phase ($I_{LS}U$, $I_{LS}V$, $I_{LS}W$, $I_{LS}X$, $I_{LS}Y$) dans toutes les branches inférieures étant mesurés indépendamment des instants de commutation du régime de redressement actif.

6. Procédé selon l'une des revendications précédentes, les courants de phase ($I_U$, $I_V$, $I_W$, $I_X$, $I_Y$) étant déterminés à partir du nombre de courants de branche de phase ($I_{LS}U$, $I_{LS}V$, $I_{LS}W$, $I_{LS}X$, $I_{LS}Y$) en tenant compte des écarts angulaires entre les au moins quatre phases (U, V, W, X, Y).

7. Procédé selon l'une des revendications précédentes, une tension de batterie étant appliquée entre la borne de tension continue supérieure (5) et la borne de tension continue inférieure (6).

8. Unité de calcul, laquelle est conçue pour mettre en oeuvre un procédé selon l'une des revendications précédentes.

9. Réseau de bord de véhicule automobile équipé d'une machine électrique comprenant un convertisseur de courant (20) et un stator (10) ayant au moins quatre phases (U, V, W, X, Y), le convertisseur de courant (20) possédant pour chacune des au moins quatre phases (U, V, W, X, Y) une branche supérieure comportant un commutateur supérieur (2) et une branche inférieure comportant un commutateur inférieur (3), toutes les branches supérieures étant reliées à une borne de tension continue supérieure (5) et toutes les branches inférieures à une borne de tension continue inférieure (6), et comprenant une unité de calcul selon la revendication 8.

10. Réseau de bord de véhicule automobile selon la revendication 9, comprenant un accumulateur d'énergie électrique (40) qui est raccordé entre la borne de tension continue supérieure (5) et la borne de tension continue inférieure (6).

11. Programme informatique qui amène une unité de calcul à mettre en oeuvre un procédé selon l'une des revendications 1 à 8 lorsqu'il est exécuté sur l'unité de calcul.

12. Support d'enregistrement lisible par machine sur lequel est enregistré un programme informatique selon la revendication 12.

Fig. 1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10327690 B4
- DE 102012217116 A1